# EUROPEAN PATENT SPECIFICATION

(11) **EP 0 335 395 B1**
(45) Date of publication and mention of the grant of the patent: **22.06.1994**
(21) Application number: 89105629.3
(22) Date of filing: 30.03.1989
(51) Int. Cl.: H01L 29/78, H01L 21/28, H01L 27/10, G11C 17/00

(54) **Non-volatile semiconductor memory device and method for manufacture thereof**
Nichtflüchtige Halbleiterspeicheranordnung und Verfahren zu ihrer Herstellung
Dispositif de mémoire non volatile à semi-conducteur et méthode pour sa fabrication

(30) Priority: 30.03.1988 JP 77671/88
(43) Date of publication of application: 04.10.1989
(73) Proprietor: KABUSHIKI KAISHA TOSHIBA, Kawasaki-shi, Kanagawa-ken 210 (JP)
(72) Inventor: Naruke, Kiyomi 206, High Town Takashima-cho, Yokohama-shi Kanagawa-ken (JP)
(74) Representative: Ritter und Edler von Fischern, Bernhard,Dipl.-Ing.

(56) References cited:
- EP-A- 0 193 841
- EP-A- 0 228 761
- US-A- 4 099 196
- US-A- 4 462 090

## Description

### BACKGROUND OF THE INVENTION

This invention relates to a non-volatile semiconductor memory device, and more particularly to the cell structure of EEPROM, and the method of operation, and the method for manufacture thereof.

Conventional non-volatile semiconductor memory devices have mainly been EPROM which has a two-layer stacked gate electrode structure. The Exel type, the Seeq type and the source side injection type are known as three types of non-volatile semiconductor memory of this kind.

### (1) Exel-type devices

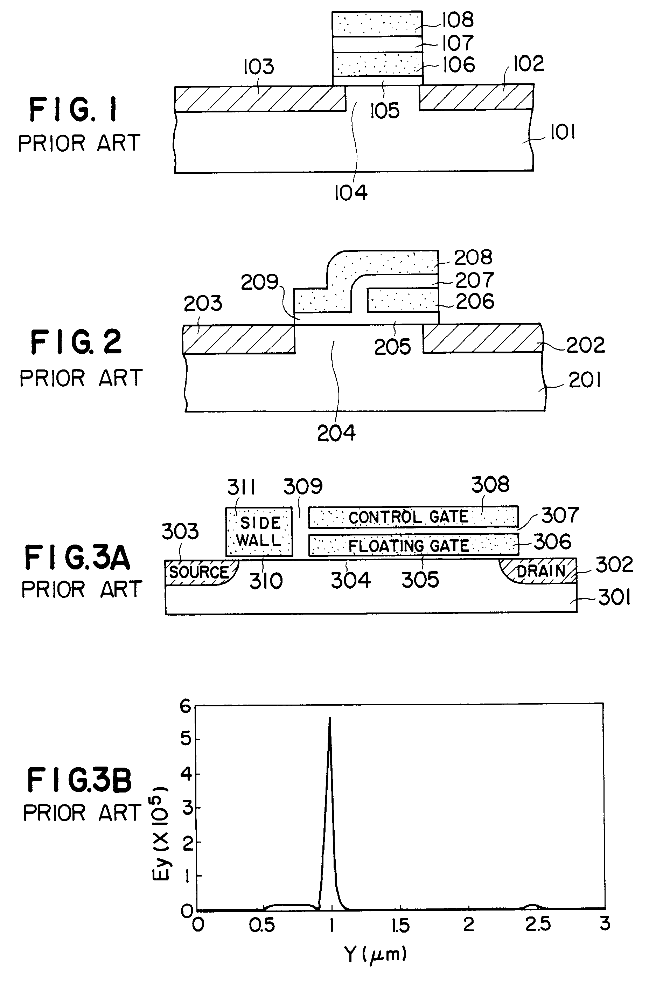

Fig. 1 is a sectional drawing indicating the structure of one cell of the Exel type memory. On the surface of a semiconductor substrate 101 is formed with the first impurity-diffused area 102 (the drain) and the second impurity-diffused area 103 (the source), and a channel area 104 between them. On top of this channel area 104, there is a gate insulation layer 105 on top of which there are a first gate electrode 106 and a second gate electrode 108. An insulation layer 107 separates the two gate electrodes. The first gate electrode 106 is a floating gate to store the charge carrier and the second gate electrode 108 is the control gate that controls the functions as a memory.

In this device, the write(charge)-operation is performed such that the second impurity-diffused area 103 is made 0V, and the second gate electrode 108 and the first impurity-diffused area 102 are both applied positive voltages to generate channel hot electrons which are injected into the first gate electrode which is the floating gate. Erase(discharge)-operation is performed by placing the first impurity-diffused area 102 in the floating status, making the second gate electrode 108 0V, and applying a positive voltage to the second impurity-diffused area 103. By doing this, the electron in the first gate electrode 106 is extracted into the second impurity-diffused area 103. This phenomenon is known as the Fowler-Nordheim Tunnel Phenomenon (and simply called "the FNT phenomenon", hereinafter).

### (2) Seeq-type devices

Fig. 2 is a sectional drawing indicating the structure of one cell of a non-volatile semiconductor memory device of the Seeq type. On the surface of a semiconductor substrate 201, there are formed the first impurity-diffused area 202 (the drain) and the second impurity-diffused area 203 (the source), and a channel area 204 between them. To the top of this channel area 204, there is a gate insulation layer 205 on top of which there are the first gate electrode 206 and the second gate electrode 208. An insulation layer 207 separates the two gate electrodes. The source side part of the second gate electrode 208 (the left side part, in Fig. 2), extends over the semiconductor substrate 201, separated from it by a second gate insulation layer 209. In the same way as for the Exel type, the first gate electrode 206 is the floating gate to store the charge carrier. The characteristic feature of the Seeq type is that the right side part of the No. 2 gate electrode 208 operates as a control gate to control the function as a memory, and that the left side part operates as a selector gate to select the cell.

In this device, the write(charge)-operation is the same as that for the Exel type. Erase(discharge)-operation is performed by placing the second impurity-diffused area 203 in the floating status, making the second gate electrode 208 0V, and applying a positive voltage to the first impurity-diffused area 202. By doing this, the electron in the first gate electrode 206 is extracted into the first impurity-diffused area 202 by the FNT phenomenon.

### (3) Source side injection type devices

Fig. 3A is a sectional drawing indicating the structure of one cell of a conventional non-volatile semiconductor memory device of the source side injection type (SIEPROM), as described in "A NOVEL HIGH-SPEED, 5-VOLT PROGRAMMING EPROM STRUCTURE WITH SOURCE-SIDE INJECTION", 1986, IEDM Digest of Technical Papers (pp. 584-587). On the surface of a semiconductor substrate 301, there are formed the first impurity-diffused area 302 (the drain) and the second impurity-diffused area 303 (the source), and a channel area 304 between them. To the top of this channel area 304, there is a gate insulation layer 305 on top of which there are the first gate electrode 306, another gate insulation layer 307, and the second gate electrode 308, in order. In addition, on the source side of the first gate electrode 306 and the second gate electrode 308, there is a side insulation layer 309, on the source side of which is the third gate electrode 311, separated from the semiconductor substrate surface by the second gate insulation layer 310. The first gate electrode 306 is the floating gate to store the charge carrier, and the third gate electrode 311 is also in a floating status.

In this device, the write(charge)-operation is performed such that a voltage of 5V is applied to the first impurity-diffused area 302 (the drain), a voltage of 0V is applied to the second impurity-diffused area 303 (the source), and a high voltage (of approximately 15V) is applied to the second gate electrode 308. Upon doing this, the first gate electrode 306 and the third gate electrode 311 have their voltages raised to approximately 12V and 4V respectively, by capacitive coupling. This forms the channel in the channel area and the electron flows from the source to the drain. Fig. 3B illustrates the distribution of the electrical field Ey across the device in Fig. 3A. As is indicated by Fig. 3B, the maximum value of the electrical field in the channel area is generated at the gap between the stacked gate 306, 308 and the third gate electrode 311, where the electrons flowing in the channel become hot, and enter the first gate electrode 306. The third gate electrode is present to make this gap.

In this device, erase is performed by illuminating ultraviolet light. Therefore, when erase is performed, the first gate electrode 306 (the floating gate) is not overerased but is in a neutral status. When read is performed, in a non-selected cell, a voltage of 0V is applied to the second gate electrode, thus the channel beneath the floating gate 306 is in the off status. Accordingly, even if the third gate electrode 311 (which is in the floating status) is positively charged to form a channel beneath it, in a non-selected cell, a cell current cannot flow. Therefore, selectivity is ensured.

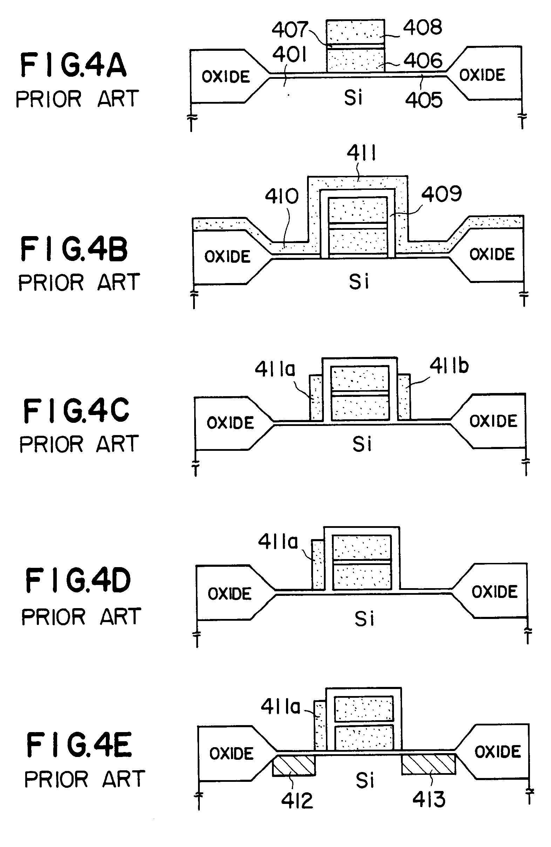

Next, Fig. 4A to 4E are sectional drawings indicating the method of manufacture of the device shown in Fig. 3A.

First, the stacked gate including the first gate electrode 406, the interlayer-insulation layer 407, and the second gate electrode 408, is formed on the gate insulation layer 405 (Fig. 4A). Then, the side wall insulation layer 409 and the second gate insulation layer 410 are formed, and poly-Si to become the third gate electrode 411 is deposited over the surface (Fig. 4B). The polysilicon is removed by anisotropic etching to leave only the third gate electrodes 411 on the side walls (Fig. 4C). Then, the poly-Si 411b on the drain area side is removed by poly-Si etching after resist patterning (Fig. 4D). After this, the source area 412 and the drain area 413 are both formed simultaneously by ion implantation (Fig. 4E).

However, there are the following problems in non-volatile semiconductor storage devices of these types described above.

### (1) Exel-type devices

The Exel-type device generally has the merits of enabling small cells and a high degree of integration, but there is the problem of overerase. When during erase, too many electrons are extracted from the floating gate, and threshold voltage with respect to the control gate becomes negative. Therefore, when read is performed, regardless of whether or not those cells have been selected, there is a current flowing in these cells, and the currents of the selected cells have the currents of the non-selected cells mixed in. As a result, it is not possible to correctly read the status of the selected cells.

### (2) Seeq-type devices

The Seeq-type device has a measure to prevent the problem of overerase. This is to say that as shown in Fig. 2, the left side part of the second gate electrode 208 is in contact with the channel area 204 via the second gate insulation layer 209, and functions as a selector gate. Therefore, even if a non-selected cell is in an overerase status, since a voltage is not applied to the second gate electrode 208 during read, the channel beneath the second gate insulation layer 209 is blocked and a current does not flow. Because of this, currents only the selected cells can be monitored at all times, and correct read is possible.

However, Seeq-type devices have a different problem owing to the gate structure. As shown in Fig. 2, the right side part is a double-layer structure of the first gate electrode 206 and the second gate electrode 208, while the left side part is a single-layer structure of only the second gate electrode. Moreover, the left side part and the right side part of the second gate electrode 208 have different vertical positions. With the present level of technology, it is extremely difficult to form such a gate structure by self-alignment etching. Because self-alignment etching cannot be performed, deviations in the mask alignment have to be considered and high-precision processing cannot be performed. Because of this, there is no choice hut to make the cells large, thereby producing obstacles to miniaturization or high integration.

There is also another problem in these Seeq-type cells. There is a gap between the offset gate (the left side part of the second gate electrode 208 in Fig. 2) and the first gate electrode 206 (the floating gate), and the electrons become hot at this gap in the same way as they do for the operation of SIEPROM. Because the voltage at the offset gate 208 is higher than the voltage of the floating gate 206, most of the generated electrons are injected into the offset gate 208, with only a small amount being injected into the floating gate 206. In this cell, the hot electrons are generated in the edge of the drain. Because of this, in order to raise the hot electrode generation ratio and the write speed, it is desirable to increase the density of the drain 202. However, for erase, a high voltage is applied to the drain 202 and the FNT phenomenon extracts the electrons into the drain 202 from the floating gate 206. Therefore, it is necessary that the drain 202 have a withstand voltage to a certain degree, and achieving this makes it desirable to decrease the density of the drain 202. The difficulty of forming the drain area stems from these two contradictory conditions.

The Exel-type cells and the SIEPROM do not have this difficulty of forming such an impurity-diffused area. the reason why is because in the Exel type, hot electrodes generated at the end of the first impurity-diffused area 102 (the drain), are injected to the first gate electrode 106 (the floating gate), for erase, a high voltage is applied to the second impurity-diffused area 103 (the source) and the electrons are extracted from the floating gate 106 to the source 103 by the FNT phenomenon, and therefore, the impurity-diffused areas of the injection side and the erase side are different and so it is possible to optimize both areas, and in addition, in SIEPROM, generating hot electrons and injecting them in the first gate electrode 306 (the floating gate) occurs in the gap between the third gate electrode 311 and the stacked gate 306, 307, 308, and since erase is performed by illuminating ultraviolet light, neither injection nor erase is influenced by the density of the impurity-diffused area.

### (3) SIEPROM

The problem with cells having this structure is that they are not suitable to EPROM (EEPROM) that can be erased electrically. In other words, if erase is performed by applying a high voltage to the drain, so that the FNT phenomenon extracts the electrons from the first gate (the floating gate) into the drain, then scattering of the Vₚ₋ₚ and scattering in thickness of the gate insulation layer 305 will induce overerase of the first gate electrode 306. If overerase occurs, a channel is formed under the floating gate 306 when there is read. When this happens, since the third gate electrode 311 is in floating state, this electrode 311 is charged positively and a channel is formed beneath it. As a result, during read, a current flows even in non-selected cells and the selectivity cannot be guaranteed. In short, because the third gate electrode is floating, selectivity of the cells cannot be guaranteed for read if electrical erase methods are used.

US-A-4 462 090 describes a semiconductor memory element having semiconductor substrate source and drain regions formed in the substrate, a first gate insulation layer formed on the major surface of the substrate, corresponding to a channel region located between the source and drain, a floating gate electrode formed on the first gate insulation layer so as to partially overlap the channel region, a second gate insulation layer formed on the floating gate electrode, a control gate electrode formed on the second gate insulation layer so as to partially overlap the floating gate electrode and an addressing gate electrode formed on the control gate electrode, extending to a portion of the channel region not covered by the floating gate electrode and the control gate electrode.

### SUMMARY OF THE INVENTION

The purpose of this invention is to provide a non-volatile semiconductor memory device that can be electrically erased, that produces no read errors due to overerase, and that allows a high level of integration.

The first aspect of this invention is to provide a non-volatile semiconductor memory device that can be electrically written and erased, comprising a semiconductor substrate, a first impurity-diffused area and a second impurity-diffused area with conduction opposite that of the semiconductor substrate at the surface of which they are provided, said first and second impurity diffused areas forming drain and source regions respectively, a stacked gate including a first gate electrode, provided via a first gate insulation layer above a channel region between the two impurity-diffused areas on the semiconductor substrate, a second gate electrode provided via an inter-layer insulation layer on the first gate electrode, a first portion of a third gate electrode provided via a second gate insulation layer on the first impurity-diffused area and via a first sidewall insulation layer on a sidewall of the stacke gate, and a wiring means for supplying predetermined voltages to the first impurity-diffused area, the second impurity-diffused area, the second gate electrode and the third gate electrode, respectively, characterised in that a second portion of said third gate electrode is provided via a third gate insulation layer on the channel region and via a second sidewall insulation layer on the other siedewall of the stacked gate.

The second aspect of this invention is to provide a method for driving the non-volatile semiconductor memory device, comprising the steps of; in the case of write, applying voltages of the same polarity to the second gate electrode, the third gate electrode and the first impurity-diffused area to inject channel hot carriers into the first gate electrode; in the case of erase, applying a voltage of the polarity to the first impurity-diffused area to extract the charge carriers from the first gate electrode through the first gate insulation layer; and in the case of read, applying a voltage of the polarity to the third gate electrode, and applying voltages of the same polarity but of a lower voltage than that used for write, to the second gate electrode and the first impurity-diffused area respectively, whereby the presence of channel formation beneath the first gate electrode is determined, so that it is checked whether or not there is charge carriers in the first gate electrode.

The third aspect of this invention is to provide a method for manufacturing the non-volatile semiconductor memory device, comprising the steps of; forming the first gate insulation layer, the first gate electrode, the inter-layer insulation layer, and the second gate electrode, which are stacked together in order on the semiconductor substrate; forming the first impurity-diffused area using the stacked layers as a mask; forming the second gate insulation layer on the semiconductor substrate around the stacked layers, and forming the sidewall insulation layer on the sidewall of the stacked layers; forming the third gate electrode on the sidewall insulation layer and the second gate electrode layers, forming the second impurity-diffused area using a first portion of the third gate electrode as a mask.

In the non-volatile semiconductor memory device of this invention, the third gate electrode can be used as a selector gate by applying a considerably large voltage to it. This is to say that even if overerase caused by electrical erase, current flowing in non-selected cells is cut by the selector gate so that no influence to the selected cells is caused. Currect read is therefore possible for the selected cells.

In the non-volatile semiconductor memory device of this invention, each electrode can be manufactured using self-allignment processes, and therefore realize miniaturization and high levels of integration.

### BRIEF DESCRIPTION OF THE DRAWINGS

Fig. 1 is a sectional view showing the structure of a non-volatile semiconductor memory device of a conventional Exel type.

Fig. 2 is a sectional view showing the structure of a non-volatile semiconductor memory device of a conventional Seeq type.

Fig. 3A is a sectional view showing the structure of a non-volatile semiconductor memory device of a conventional SIEPROM.

Fig. 3B is a graph indicating the electric vield distribution in the device in Fig. 3A.

Figs. 4A to 4E are sectional views indicating the manufacturing processes of the device in Fig. 3A.

Fig. 5 is a sectional drawing showing one embodiment of the non-volatile semiconductor storage device of this invention.

Fig. 6 is a graph indicating the actually measured values for the current flowing in non-selected cells, for both the embodiment of the non-volatile semiconductor memory device of this invention shown in Fig. 5, and the conventional Exel device.

Figs. 7A to 7H are sectional views illustrating one example of the manufacturing process for the non-volatile semiconductor memory device of this invention shown in Fig. 5.

Fig. 8A is a plan view illustrating one embodiment of the actual plan layout of the device in Fig. 5.

Fig. 8B is a section taken along the line A-A′ in Fig. 8A.

Fig. 8C is a section taken along the line B-B′ in Fig. 8A.

Fig. 9 is a plan view showing the method of obtaining the structure of the third gate electrode in Fig. 8A.

Fig. 10 is a plan view showing another embodiment of the plan layout of the device in Fig. 5.

Fig. 11 is a plan view showing one embodiment of the plan layout when individual cells of Fig. 8 are laid out as an array.

### DESCRIPTION OF THE PREFERRED EMBODIMENT

The following will describe a preferred embodiment of this invention.

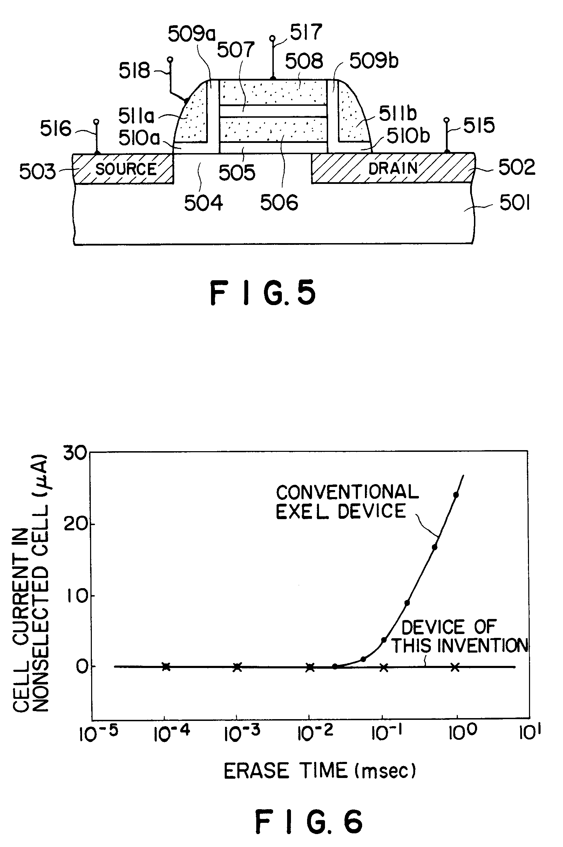

Fig. 5 is a sectional view indicating the structure of the non-volatile semiconductor memory device that is a preferred embodiment of this invention. In a semiconductor substrate 501 are formed the first impurity-diffused area 502 (drain) and the second impurity-diffused area 503 (source), with a channel area (504) between them. Above this channel area 504 is formed a stacked gate comprising the first gate insulation layer 505, the first gate electrode 506, an inter-layer insulation layer 507, and the second gate electrode 508. On the sidewalls of this stacked gate are formed sidewall insulation layers 509a and 509b. These sidewall insulation layers 509a and 509b are in contact with the second gate insulation layers 510a and 510b formed on the semiconductor substrate 501. On these sidewall insulation layers 509a and 509b and the second gate insulation layers 510a and 510b are formed the third gate electrodes 511a and 511b. Wiring 515, 516, 517 and 518 are connected to the first impurity-diffused area 502, the second impurity-diffused area 503, the second gate electrode 508 and the third gate electrode 511a, respectively, in order to apply predetermined voltages to them.

In this embodiment, the semiconductor substrate 501 is a silicon substrate, each of the insulation layers is a silicon oxide layer, each of the gate electrodes are of poly-Si, and the wiring is of aluminum. Of the three electrodes, the first gate electrode 506 is the floating electrode to store the charge, the second gate electrode 508 is the control electrode to control the operations of write, erase and read, and the third gate electrode 511a functions as the selector gate to select the cell.

The following is an explanation of the write, erase and read operations for the device indicated in Fig. 5.

### (1) Write operation

For write, positive voltages are applied to the second gate electrode 508, the third gate electrode 511a and the first impurity-diffused area 502. Then channel hot carriers are injected into the first gate electrode 506 to perform write.

### (2) Erase operation

For erase, a positive voltage is applied to the first impurity-diffused area 502, and the charge carrier in the first gate electrode 506 is extracted into the first impurity-diffused area 502 through the first gate insulation layer 505 by the FNT phenomenon.

### (3) Read operation

For read, a positive voltage is applied to the third gate electrode 511, a voltage of 0V or a positive voltage lower than the voltage used for write is applied to the second gate electrode 508, and a positive voltage lower than the voltage used for write is applied to the first impurity-diffused area 502. In this status, checking whether or not there is channel formation beneath the first gate electrode 506 enables check for whether or not there is a charge carrier in the first gate electrode.

Next, these three operations will be described more concretely, using an example values for the applied voltages.

| | WRITE | ERASE | READ |
|---|---|---|---|
| the first impurity-diffused area (102) | 5V or more | 10V or more | 5V or less |
| the second impurity-diffused area (103) | 0V | floating | 0V |
| the second gate electrode (108) | 10V or more | 0V | 0V or more |
| the third gate electrode (111) | 1V or more | 0V | 1V or more |

Fig. 6 is a graph indicating the relationship between the erase time and the measured values for the cell current flowing in the non-selected cells during read after erase operation. The graph compares the values for the device according to the embodiment, and a conventional Exel device. As can be seen from this graph, the conventional Exel type device has a rapid increase in the non-selected cell current when the erase time is 10⁻² (m sec) or more, while there is no increase in the non-selected cell current for the device according to this invention. As has been stated, overerase occurs when the erase time becomes longer. In this case, in conventional devices of the Exel type, current also flows in non-selected cells when read is performed, but with the device according to this invention, this current is cut by the gate function of the third gate electrode.

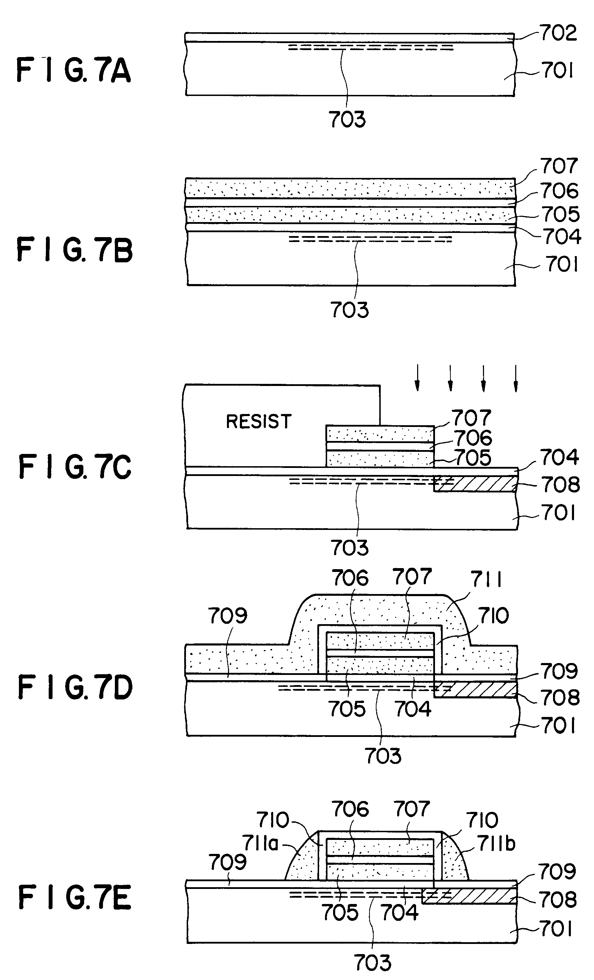

The following will use the process drawings Fig. 7A to 7H to describe the process of manufacturing the device shown in Fig. 5.

### (1) Process shown in Fig. 7A

On a P-type silicon substrate 701 (resistance: 10 Ω·cm) having Miller indices of 100, is formed a field oxide layer (not indicated in the drawing) by the normal LOCOS method, and the part surrounded by this field oxide layer is made the element area. Then, the thermal oxidation method is used to form a sacrificial oxide layer 702 of approximately 10 nm (100Å) in thickness, on the surface of the silicon substrate 701. Following this, channel ions 703 for threshold value control, are implanted through the sacrificial oxide layer 702.

### (2) Process shown in Fig. 7B

The sacrificial oxide layer 702 is removed by etching with NH₄F liquid and the thermal oxidation method is used to form the first gate oxidation layer 704 of approximately 10 nm (100Å) in thickness. Then, the LPCVD method is used to deposit the first poly-Si electrode 705 of approximately 400 nm (4000Å) in thickness on top of the first gate oxidation layer 704. Then, the vapor diffusion method with POCl₃ is used to diffuse phosphorous in the first poly-Si electrode 705. After this, the resist patterning and etching is performed to form the cell slit (not indicated in the drawing). Then, the inter-layer poly-Si oxidation layer 706 of approximately 30 nm (300Å) in thickness is formed by the thermal oxidation method. Following this, the LPCVD method is used to deposit the second poly-Si electrode 707 of approximately 400 nm (4000Å) in thickness on the inter-layer poly-Si oxidation layer 706. Then, the vapor diffusion method with POCl₃ is used to diffuse phosphorous in the second poly-Si electrode 707.

### (3) Process shown in Fig. 7C

Resist patterning and anisotropic etching is then performed for the each of the layers of the first poly-Si electrode 705, inter-layer poly-Si oxide layer 706, and the second poly-Si electrode 707, to leave the parts essential for the cell. Then, after the resist patterning, arsenic ions are implanted in the surface of the silicon substrate 701 under the conditions of 40keV, 1 × 10¹⁴ cm⁻², to form the first impurity-diffused area 708.

### (4) Process shown in Fig. 7D

Following this, the thermal oxidation method is used to form the second gate oxidation layer 709 of approximately 15 nm (150Å) in thickness and a side wall poly-Si oxidation layer 710 of approximately 30 nm (300Å) in thickness Then, the LPCVD method is used to deposit the third poly-Si electrode 711, and phosphorous is thermally diffused to this.

### (5) Process shown in Fig. 7E

After resist patterning is performed, anisotropic etching is performed to remove the third poly-Si electrode 711, remaining only the third poly-Si electrode 711a and 711b on the side wall of the stacked gate of the first poly-Si electrode 705 and the second poly-Si electrode 707.

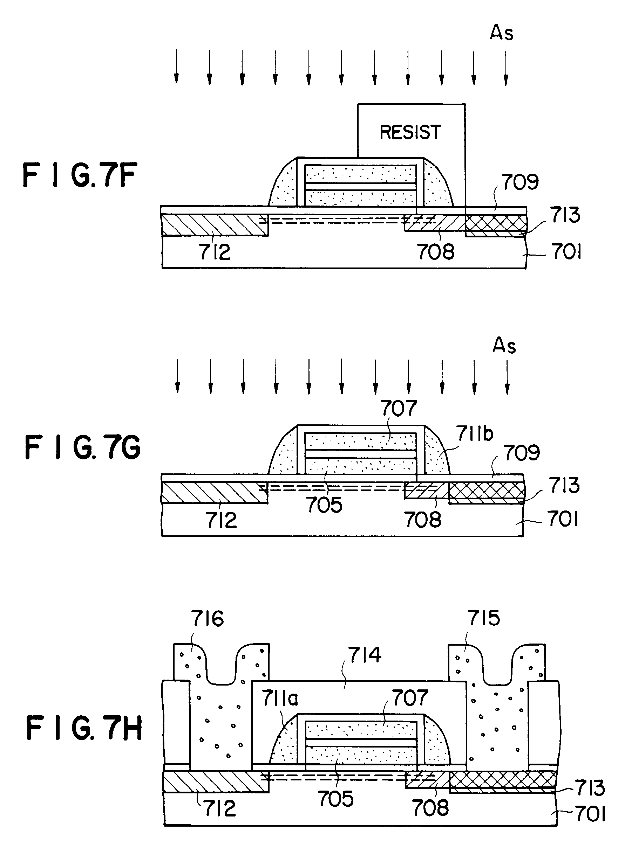

### (6) Process shown in Fig. 7F or 7G

Following resist patterning, arsenic ions are implanted in the surface of the silicon substrate 701 under the conditions of 40keV, 5 × 10¹⁵ cm⁻², to form the second impurity-diffused area 712. In this case, either the process shown in Fig. 7F or that shown in Fig. 7G can be selected. In the process shown in Fig. 7F, the resist that remains after resist patterning, covers the drain side of the gate, so that a high density area 713 is separated from the end of the gate. In the process shown in Fig. 7G, the resist is removed so that ion implantation is performed over the entire area. After doing this, the third gate electrode 711b of the side wall on the drain side, is used as the mask for arsenic ion implantation. By doing this, there is self-alignment for the high density area 713 so that it is separated from the edge of the stacked gate 705, 707 by a distance equal to the width of the third gate electrode 711b.

Moreover, because of the thermal processing in the above processes, the impurities in the first impurity-diffused area 713, are thermally diffused to lengthen the first impurity-diffused area 708 in the direction to the gate (to the left, in the drawing).

### (7) Process shown in Fig. 7H

Next, well-known methods are used to deposit the inter-layer insulation layer 714, to open the contact through hole, to deposit and pattern the aluminum wiring 715, 716 (the aluminum wiring with respect to the gate electrodes 707, 711 is not indicated in the drawing) with respect to the drain 708, source 712 and each of the gate electrodes 705, 707, 711a, and to deposit the protector layer (not indicated in the drawing), and other processes to complete the non-volatile semiconductor memory device.

As can be seen from the description of the above processes, a self-alignment process is used to manufacture the third gate electrode 711 to result in greater miniaturization and higher integration when compared to conventional devices of the Seeq type. More concretely, comparing the numerical values shows that although an area of 44 »m² per cell is necessary for conventional devices of the Seeq type, the area of a device according to this invention can be held down to 60% of this, to enable the manufacture of small cells of approximately the same area as conventional devices of the Exel type.

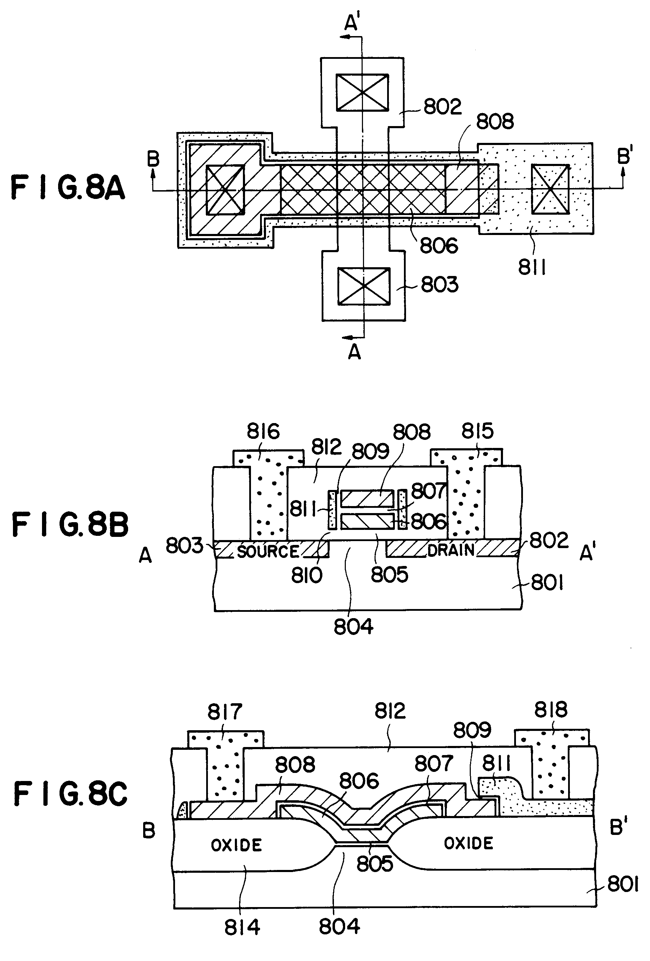

Using an individual device as an example, Fig. 8A shows an actual plan layout of the embodiment of the non-volatile semiconductor memory device of this invention. Fig. 8B and Fig. 8C are sectional views taken along the lines A-A′ and B-B′, respectively, in Fig. 8A. To facilitate contact with the metal wiring, the gate electrodes 806, 807, 809 are extended in the direction (lateral, in the drawing) perpendicular to the direction (longitudinal, in the diagram) of the drain, and the contact between the metal wiring 818 (in Fig. 8C) and the third gate electrode 811 is made at the right-hand side of Fig. 8A. In the left-hand side of Fig. 8A is made the contact between the second gate electrode 808 and the metal wiring 817 (in Fig. 8C). The part of the third gate electrode 811 to provide the contact with the metal wiring 818, is wider than the contact hole and part of it overlaps with the second gate electrode 808 so that this overlapping part is connected to the third gate electrode 811 formed along the side wall of the stacked gate of the first gate electrode 806 and the second gate electrode 808.

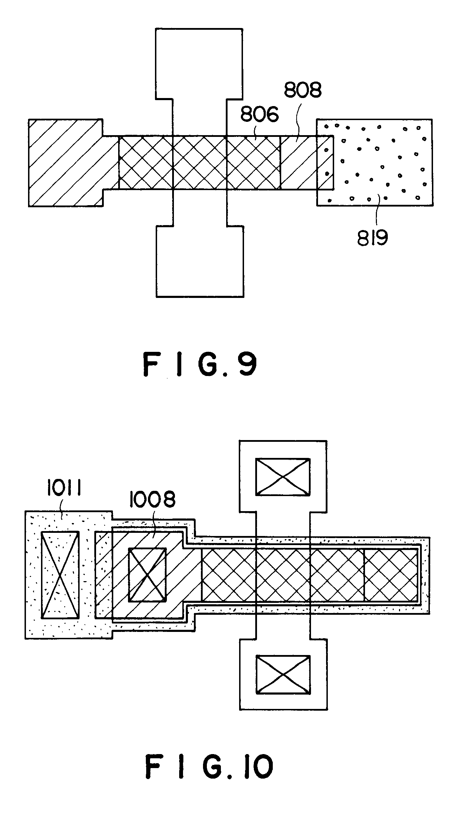

Fig. 9 illustrates the method used to obtain the shape of the third gate electrode 811 shown in Fig. 8. Fig. 8 is a plan of the patterning, after the completion of the process indicated in Fig. 7D, of the resist 819 so that it overlaps with the second gate electrode 808 under the poly-Si that is to become the third gate electrode 811. After this patterning process is completed, anisotropic etching techniques are used to etch the poly-Si that is to be the third gate electrode, so that the part of the poly-Si covered with the poly-Si resist 819 and the poly-Si along the side wall of the stacked gate remains to form the shape of the third gate electrode in Fig. 8.

Fig. 10 is a plan of an embodiment of the non-volatile semiconductor memory device of this invention, using an individual device as an example. In this embodiment, the contact between the third gate electrode 1011 and the metal wiring is made on the same side to the channel as the contact between the second gate electrode 1008 and the metal wiring.

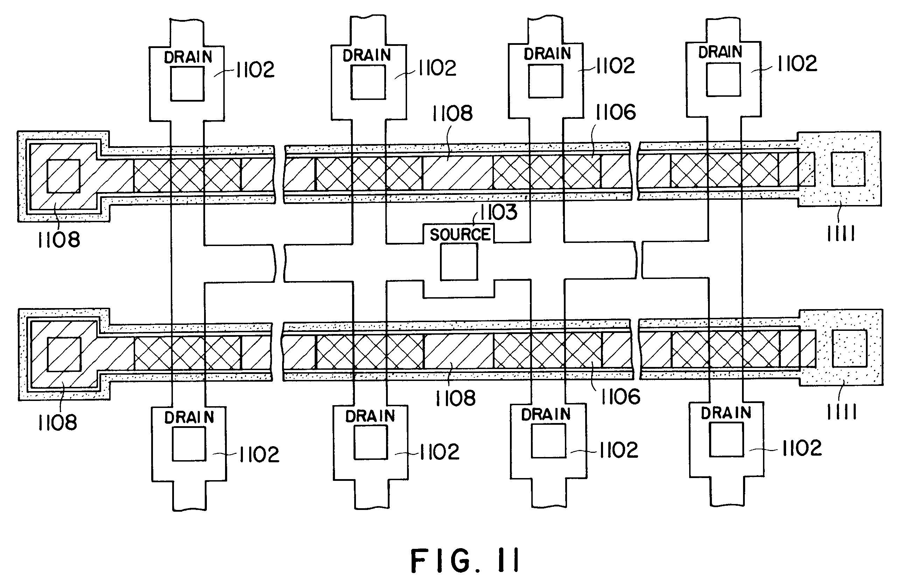

Fig. 11 is a plan on an embodiment layout where individual cells of the type of non-volatile semiconductor memory device of this invention as shown in Fig. 8, are set in an array. Although not indicated in the drawing, the metal wiring connecting the first impurity-diffused areas 1102 (drains) is connected so as to be also able to supply a same voltage to the drains 1102 above and below it. The second gate electrodes (control gates) 1108 and the third gate electrodes (select gates) 1111 both supply common voltages to more than one cell. The second impurity-diffused area 103 is the source for all of the cells connected to it. Therefore, the pattern of cells can be repeated both vertical and horizontally, with each cell sharing a drain with the cell above or below it, and sharing a source with all of the cells in that row of cells and those in the row of cells below or above it.

## Claims

1. A non-volatile semiconductor memory device that can be electrically written and erased, comprising:
a semiconductor substrate (501,701,801);
a first impurity-diffused area (502,708,802,1102) and a second impurity-diffused area (503,712,803,1103) with conduction opposite that of the semiconductor substrate (501,701,801) at the surface of which they are provided, said first and second impurity-diffused areas forming drain and source regions respectively;
a stacked gate including a first gate electrode (506,705,806,1106) provided via a first gate insulation layer (505,704,805) above a channel region (/504, 703, 804) between the two impurity-diffused areas (502,708,802,1102;503,712,803,1103) on the semiconductor substrate (501,701,801), a second gate electrode (508,707,808,1108) provided via an inter-layer insulation layer (507,706,807) on the first gate electrode (506,705,806,1106);
a first portion (511b, 711b, 811, 1111) of a third gate electrode (511,711,811,1111) provided via a second gate insulation layer (510,709,810) on the first impurity-diffused area (502, 708, 802, 1102) and via a first sidewall insulation layer (509,710,809) on a sidewall of the stacked gate, and
a wiring means (515-8;715,716;815-8) for supplying predetermined voltages to the first impurity-diffused area (502,708,802,1102), the second impurity-diffused area (503,712,803,1103), the second gate electrode (508,708,808,1108) and the third gate electrode (511,711,811,1111), respectively,
**characterized in that**
a second portion (511a, 711a, 811, 1111) of said third gate electrode (511, 711, 811, 1111) is provided via a third gate insulation layer (510, 709, 810) on the channel region (504, 703, 804) and via a second sidewall insulation layer (509, 710, 809) on the other sidewall of the stacked gate.

2. The device of claim 1, characterised in that the impurity density of the first impurity-diffused area (502,708,802,1102) is lower than that of the second impurity-diffused area (503,712,803,1103).

3. The device of claim 1, characterised in that the contact between the second gate electrode (508,708,808,1108) and the wiring means and the contact between the third gate electrode (511,711,811,1111) and the wiring means are provided on opposite sides of the channel region.

4. The device of claim 1, characterised in that the second gate electrode (508, 707, 808, 1108) and the third gate electrode (511, 711, 811, 1111) are extended in the direction substantially perpendicular to the direction from the first impurity-diffused area (502, 708, 802, 1102) to the second impurity-diffused area (503, 712, 803, 1103).

5. The device of claim 1, characterised in that the contact between the second gate electrode (508,708,808,1008,1108) and the wiring means and the contact between the third gate electrode (511,711,811,1111) and the wiring means are provided on the same side of the channel region.

6. A non-volatile memory device comprising a multiplicity of memory devices according to claim 1, characterised in that said multiple individual memory devices are set in an array extending in the direction of the gate electrodes and where the individual cells share the second impurity-diffused area (503,712,803,1103), the second gate electrode (508,708,808,1008,1108) and the third gate electrode (511,711,811,1011,1111).

7. A method for driving the non-volatile semiconductor memory device of claim 1, comprising the steps of:
in the case of write, applying voltages of the same polarity to the second gate electrode (508,707,808,1008,1108), the third gate electrode (511,711,811,1011,1111) and the first impurity-diffused area (502,708,802,1102) to inject channel hot carriers into the first gate electrode (506,705,806,1106);
in the case of erase, applying a voltage of said polarity to the first impurity-diffused area (502,708,802,1102) to extract the charge carriers from the first gate electrode (506,705,806,1106) through the first gate insulation layer (505,704,805);
and in the case of read, applying a voltage of said polarity to the third gate electrode (511,711,811,1011,1111) and applying voltages of the same polarity but of a lower voltage than that used for write to the second gate electrode (508,707,808,1008,1108) and the first impurity-diffused area (502,708,802,1102) respectively, whereby the presence of channel formation beneath the first gate electrode (506,705,806,1106) can be determined so that it is checked whether or not there is a charge carrier in the first gate electrode (506,705,806,1106).

8. A method for manufacturing the non-volatile semiconductor memory device of claim 1, comprising the steps of:
forming a first gate insulation layer (704), a first gate electrode (705), the inter-layer insulation layer (706) and a second gate electrode (707), which are stacked in order on a semiconductor substrate (701);
forming a first impurity-diffused area (708) in the substrate (701) using the stacked layers (705,706,707) as a mask;
forming a second gate insulation layer (709) around the stacked layers (705,706,707) and forming sidewall insulation layers (710) on the sidewalls of the stacked layers (705,706,707);
forming a third gate electrode (711a, 711b) on the sidewall insulation layers (710) and the second gate insulation layer (709); and
forming a second impurity-diffused area (712) in the substrate (701), using a first portion of the third gate electrode (711a, 711b) as a mask.

9. The method of claim 8, having another step of forming a high density area (713) in a selected part of the first impurity-diffused area (708) simultaneously with the formation of the second impurity-diffused area (712).

## Patentansprüche

1. Nicht-flüchtige Halbleiterspeichervorrichtung, welche elektrisch beschrieben und gelöscht werden kann, mit:
einem Halbleitersubstrat (501,701,801);
einem ersten verunreinigungsdiffundierten Bereich (502,708,802,1102) und einem zweiten verunreinigungsdiffundierten Bereich (503,712,803,1103) mit einem Leitungstyp, der entgegengesetzt ist dem des Halbleitersubstrats (501, 701, 801), an dessen Oberfläche sie vorgesehen sind, wobei der erste und zweite verunreinigungsdiffundierte Bereich einen Drain- und Sourcebereich bilden;
einem Stapelgate einschließlich einer ersten Gateelektrode (506,705,806,1106), vorgesehen über einer ersten Gateisolationsschicht (505,704,805) oberhalb eines Kanalbereichs (504,703,804) zwischen den zwei verunreinigungsdiffundierten Bereichen (502,708,802,1102; 503,712,803,1103) auf dem Halbleitersubstrat (501,701,801), einer zweiten Gateelektrode (508,707,808,1108) vorgesehen über einer Zwischenschicht-Isolationsschicht (507,706,807) auf der ersten Gateelektrode (506,705,806,1106);
einem ersten Abschnitt (511b,711b,811,1111) einer dritten Gateelektrode (511,711,811,1111), vorgesehen über einer zweiten Gateisolationsschicht (510,709,810) auf dem ersten verunreinigungsdiffundierten Bereich (502,708,802,1102) und über einer ersten Seitenwand-Isolationsschicht (509,710,809) auf einer Seitenwand des Stapelgates; und
einer Verdrahtungseinrichtung (515-8;715,716;815-8) zum Zuführen vorbestimmter Spannungen an den ersten verunreinigungsdiffundierten Bereich (502,708,802,1102), den zweiten verunreinigungsdiffundierten Bereich (503,712,803, 1103), die zweite Gateelektrode (508,708,808,1108) und die dritte Gateelektrode (511,711,811,1111),
dadurch **gekennzeichnet**, daß
ein zweiter Abschnitt (511a,711a,811,1111) der dritten Gateelektrode (511,711,811,1111) vorgesehen ist über einer dritten Gateisolationsschicht (510,709,810) auf dem Kanalbereich (504,703,804) und über einer zweiten Seitenwand-Isolationsschicht (509,710,809) auf der anderen Seitenwand des Stapelgates.

2. Vorrichtung nach Anspruch 1, dadurch gekennzeichnet, daß die Verunreinigungsdichte des ersten verunreinigungsdiffundierten Bereichs (502,708,802,1102) niedriger ist als die des zweiten verunreinigungsdiffundierten Bereichs (503,712,803,1103).

3. Vorrichtung nach Anspruch 1, dadurch gekennzeichnet, daß der Kontakt zwischen der zweiten Gatelektrode (508,708,808, 1108) und der Verdrahtungseinrichtung und der Kontakt zwischen der dritten Gateelektrode (511,711,811,1111) und der Verdrahtungseinrichtung vorgesehen sind auf gegenüberliegenden Seiten des Kanalbereichs.

4. Vorrichtung nach Anspruch 1, dadurch gekennzeichnet, daß die zweite Gateelektrode (508,707,808,1108) und die dritte Gateelektrode (511,711,811,1111) sich in die Richtung im wesentlichen senkrecht zur Richtung vom ersten veruneinigungsdifffundierten Bereich (502,708,802,1102) zum zweiten verunreinigungsdiffundierten Bereich (503,712,803, 1103) erstrecken.

5. Vorrichtung nach Anspruch 1, dadurch gekennzeichnet, daß der Kontakt zwischen der zweiten Gatelektrode (508,708,808, 1008,1108) und der Verdrahtungseinrichtung und der Kontakt zwischen der dritten Gateelektrode (511,711,811,1111) und der Verdrahtungseinrichtung vorgesehen sind auf der gleichen Seite des Kanalbereichs.

6. Nicht-flüchtige Halbleiterspeichervorrichtung mit einer Vielzahl von Speichervorrichtungen nach Anspruch 1, dadurch gekennzeichnet, daß die Vielzahl individueller Speichervorrichtungen angeordnet sind in einem Feld, das sich erstreckt in die Richtung der Gateelektroden und wobei die individuellen Zellen den zweiten verunreinigungsdiffundierten Bereich (503,712,803,1103), die zweite Gateelektrode (508,708,808,1008,1108) und die dritte Gatelektrode (511,711,811,1011,1111) teilen.

7. Verfahren zum Ansteuern der nicht-flüchtigen Halbleiterspeichervorrichtung nach Anspruch 1 mit den Schritten:
im Fall des Schreibens Anlegen von Spannungen der gleiche Polarität an die zweite Gatelektrode (508,707,808,1008, 1108), die dritte Gatelektrode (511,711,811,1011,1111) und den ersten verunreinigungsdiffundierten Bereich (502,708,802,1102) zum Injizieren von heißen Kanalladungsträgern in die erste Gateelektrode (506,705, 806,1106);
im Fall des Löschens Anlegen einer Spannung der Polarität an den ersten verunreinigungsdiffundierten Bereich (502,708, 802,1102) zum Extrahieren der Ladungsträger von der ersten Gateelektrode (506,705,806,1106) durch die erste Gateisolationsschicht (505,704,805); und
im Fall des Lesens Anlegen einer Spannung der Polarität an die Gateelektrode (511,711,811,1011,1111) und Anlegen von Spannung derselben Polarität aber einer niedrigeren Spannung als der, welche zum Schreiben benutzt wird, an die zweite Gateelektrode (508,707,808,1008,1108) und den ersten verunreinigungsdiffundierten Bereich (502,708,802,1102), wodurch die Gegenwart einer Kanalbildung unterhalb der ersten Gateelektrode (506,705,806,1106) bestimmt werden kann, so daß geprüft wird, ob oder ob nicht es Ladungsträger in der ersten Gateelektrode (506,705,806,1106) gibt.

8. Verfahren zum Herstellen der nicht-flüchtigen Halbleiterspeichervorrichtung von Anspruch 1 mit den Schritten:
Bilden einer ersten Gateisolationsschicht (704), einer ersten Gatelektrode (705), der Zwischenschicht-Isolationsschicht (706) und einer zweiten Gateelektrode (707), welche der Reihenfolge nach auf einem Halbleitersubstrat (701) gestartet sind;
Bilden eines ersten verunreinigungsdiffundierten Bereichs (708) in dem Substrat (701) unter Benutzung der gestapelten Schicht (705, 706, 707 als Maske;
Bilden einer zweiten Gateisolationsschicht (709) um die gestapelten Schichten (705,706,707) und Bilden von Seitenwand-Isolationsschichten (710) auf den Seitenwänden der gestapelten Schicht (705,706,707);
Bilden einer dritten Gateelektrode (711a,711b) auf den seitenwand-Isolationsschichten (710) und der zwetien Gateisolationsschicht (709); und
Bilden eines zweiten verunreinigungsdiffundierten Bereichs (712) in dem Substrat (701) unter Benutzung eines ersten Abschnitts der dritten Gateelektrode (711a,711b) als Maske.

9. Verfahren nach Anspruch 8, gekennzeichnet durch einen weiteren Schritt des Bildens eines Hochdichtebereichs (713) in einem ausgewählten Teil des ersten verunreinigungsdiffundierten Bereichs (708) gleichzeitig mit der Bildung des zweiten verunreinigungsdiffundierten Bereichs (712).

## Revendications

1. Un dispositif de mémoire non volatile à semi-conducteur qui peut être écrit et effacé électriquement, comprenant:
un substrat semi-conducteur (501, 701, 801);
une première zone à diffusion d'impuretés (502, 708, 802, 1102) et une deuxième zone à diffusion d'impuretés (503, 712, 803, 1103) d'une conduction opposée à celle du substrat semi-conducteur (501, 701, 801) à la surface duquel elles sont réalisées, ladite première et ladite deuxième zones à diffusion d'impuretés formant des régions de drain et de source, respectivement;
une grille empilée incluant une première électrode de grille (506, 705, 806, 1106) réalisée au moyen d'une première couche d'isolation (505, 704, 805) de grille au-dessus d'une région de canal (504, 703, 804) située entre les deux zones à diffusion d'impuretés (502, 708, 802, 1102; 503, 712, 803, 1103) sur le support semi-conducteur (501, 701, 801), une deuxième électrode de grille (508, 707, 808, 1108) réalisée au moyen d'une couche d'isolation (507, 706, 807) entre couches sur la première électrode de grille (506, 705, 806 1106);
une première partie (511b, 711b, 811, 1111) d'une troisième électrode de grille (511, 711, 811, 1111) réalisée au moyen d'une deuxième couche d'isolation (510, 709, 810) de grille sur la première zone à diffusion d'impuretés (502, 708, 802 1102) et au moyen d'une première couche d'isolation (509, 710, 809) de paroi latérale sur une paroi latérale de la grille empilée, et
un moyen de câblage (515 à 518; 715, 716; 815 à 818) pour amener des tensions prédéterminées à la première zone à diffusion d'impuretés (502, 708, 802, 1102), à la deuxième zone à diffusion d'impuretés (503, 712, 803 1103) à la deuxième électrode de grille (508, 708, 808, 1108) et à la troisième électrode de grille (511, 711, 811, 1111), respectivement,
caractérisé en ce que
une deuxième partie (511a, 711a, 811, 1111) de ladite troisième électrode de grille (511, 711, 811, 1111) est réalisée au moyen d'une troisième couche d'isolation (510, 709, 810) de grille sur la région de canal (504, 703, 804) et au moyen d'une deuxième couche d'isolation (509, 710, 809) de paroi latérale sur l'autre paroi latérale de la grille empilée.

2. Le dispositif selon la revendication 1, caractérisé en ce que la densité d'impuretés de la première zone à diffusion d'impuretés (502, 708, 802, 1102) est inférieure à celle de la deuxième zone à diffusion d'impuretés (503, 712, 803, 1103).

3. Le dispositif selon la revendication 1, caractérisé en ce que le contact entre la deuxième électrode de grille (506, 708, 808, 1108) et le moyen de câblage et le contact entre la troisième électrode de grille (511, 711, 811, 1111) et le moyen de câblage sont réalisés sur des côtés opposés de la région de canal.

4. Le dispositif selon la revendication 1, caractérisé en ce que la deuxième électrode de grille (508, 707, 808, 1108) et la troisième électrode de grille (511, 711, 811, 1111) s'étendent dans la direction sensiblement perpendiculaire à la direction allant de la première zone à diffusion d'impuretés (502, 708, 802, 1102) à la deuxième zone à diffusion d'impuretés (503, 712, 803, 1103).

5. Le dispositif selon la revendication 1, caractérisé en ce que le contact entre la deuxième électrode de grille (506, 708, 808, 1108) et le moyen de câblage et le contact entre la troisième électrode de grille (511, 711, 811, 1111) et le moyen de câblage sont réalisés sur le même côté que la région de canal

6. Un dispositif de mémoire non volatile comprenant une multiplicité de dispositifs de mémoire selon la revendication 1, caractérisé en ce que lesdits dispositifs individuels de mémoire sont agencés en un réseau s'étendant dans la direction des électrodes de grilles et où les cellules individuelles partagent la deuxième zone à diffusion d'impuretés (503, 712, 803, 1103), la deuxième électrode de grille (508, 708, 808, 1008, 1108) et la troisième électrode de grille (511, 711, 811, 1011, 1111).

7. Un procédé d'attaque du dispositif de mémoire non volatile à semi-conducteur selon la revendication 1, comprenant les étapes consistant à:
appliquer, dans le cas d'une écriture, des tensions de la même polarité à la deuxième électrode de grille (508, 707, 808, 1008, 1108), à la troisième électrode de grille (511, 711, 811, 1011, 1111) et à la première zone à diffusion d'impuretés (502, 708, 802, 1102) afin d'injecter des porteurs chauds de canaux dans la première électrode de grille (506, 705, 806, 1106);
appliquer, dans le cas d'un effacement, une tension de ladite polarité à la première zone à diffusion d'impuretés (502, 708, 802, 1102) pour extraire de la première électrode (506, 705, 806, 1106) les porteurs de charge à travers la première couche d'isolation (505, 704, 805) de grille;
et appliquer, dans le cas d'une lecture, une tension de ladite polarité à la troisième électrode de grille (511, 711, 811, 1011, 1111) et appliquer des tensions de la même polarité, mais d'une tension inférieure à celle qui est utilisée pour l'écriture, à la deuxième électrode de grille (508, 707, 808, 1008, 1108) et à la première zone à diffusion d'impuretés (502, 708, 802, 1102) respectivement, grâce à quoi la présence d'une formation de canal au-dessous de la première électrode de grille (506, 705, 806, 1106) peut être déterminée de façon qu'il soit vérifié s'il existe ou non un porteur de charge dans la première électrode de grille (506, 705, 806, 1106).

8. Un procédé de fabrication du dispositif de mémoire non volatile à semi-conducteur selon la revendication 1, comprenant les étapes consistant à:
former une première couche d'isolation (704) de grille, une première électrode de grille (705), la couche d'isolation (706) entre couches et une deuxième électrode de grille (707), qui sont empilés dans l'ordre sur un substrat semi-conducteur (701);
former dans le substrat (701) une première zone à diffusion d'impuretés (708) en utilisant comme masque les couches empilées (705, 706, 707);
former une deuxième couche d'isolation (709) de grille autour des couches empilées (705, 706, 707) pour former des couches d'isolation (7010) de parois latérales sur les parois latérales des couches empilées (705, 706, 707);
former une troisième électrode de grille (711a, 711b) sur les couches d'isolation (710) de parois latérales et sur la deuxième couche d'isolation de grille (709); et
former dans le substrat (701) une zone à diffusion d'impuretés (712), en utilisant comme masque une première partie de la troisième électrode de grille (711a, 711b).

9. Le procédé selon la revendication 8, incluant une autre étape consistant à former, de façon simultanée avec la formation de la deuxième zone à diffusion d'impuretés (712) une zone à haute densité (713) dans une partie choisie de la première zone à diffusion d'impuretés (708).
